# EUROPEAN PATENT APPLICATION

(11) **EP 4 787 003 A1**
(43) Date of publication of application: **05.08.2026**
(21) Application number: 26154823.4
(22) Date of filing: 28.01.2026
(51) Int. Cl.: G01R 33/30

(54) **NMR MEASUREMENT CELL AND NMR MEASUREMENT PROBE**

(30) Priority: 03.02.2025 JP 2025016209
(71) Applicant: Jeol Ltd., Akishima, Tokyo 196-8558 (JP)
(72) Inventor: ENDO, Yuki, Japan, 196-8558 (JP); SASAKI, Reiko, Japan, 196-8558 (JP)
(74) Representative: Boult Wade Tennant LLP

(57) **Abstract**

A battery sample is contained in a cell body (64). A first pin (74) having two O rings (110, 112) is inserted into a first pin hole (106) formed on the cell body (64). A second pin (78) having two O rings (122, 124) is inserted into a second pin hole (118) formed on the cell body (64). The battery sample and the two pins (74, 78) are electrically connected to each other by two connection members (116, 128).

## Description

### TECHNICAL FIELD

The present disclosure relates to a cell for NMR measurement (NMR measurement cell) and a probe for NMR measurement (NMR measurement probe) having the NMR measurement cell, and in particular to NMR measurement of a battery sample which is charged and discharged.

### BACKGROUND

Various secondary batteries (batteries of charge-discharge type; hereinafter simply referred to as "batteries") such as lithium ion batteries are widely in use. In recent years, solid-state batteries having solid electrolytes are being developed.

Various measurement apparatuses are used for evaluating performance and behavior of the batteries. One such measurement apparatus is an NMR (Nuclear Magnetic Resonance) measurement apparatus. For example, a layered assembly corresponding to a portion of a battery is disposed within a probe of the NMR measurement apparatus. The layered assembly can also be referred to as a battery sample. While the battery sample is repeatedly charged and discharged, NMR generated in the battery sample is measured. There is a demand for realizing a highly practical battery sample container (NMR measurement cell) for such in-situ measurement.

Document 1 (US 6,538,444 B) discloses an NMR measurement apparatus having a cavity for containing a sample and a mechanism which changes an angle of the cavity. Document 2 (US 9,194,920 B) discloses an NMR measurement apparatus having a mechanism which rotates a sample chamber. Documents 1 and 2 do not disclose facilities for measuring NMR generated in a battery during charging and discharging of the battery.

Document 3 (US 10,126,366 B) discloses an NMR measurement apparatus having an assembly including a battery sample. The battery sample has two conductors which extend from inside of the assembly to the outside of the assembly. The two conductors cannot be replaced, or the replacement of the two conductors is very difficult. Document 4 (US 11,215,686 B) discloses a technique for measuring the NMR generated in the battery sample.

None of Documents 1 to 4 disclose an easily replaceable conductor used for charging and discharging the battery sample, or a sealing structure for such a conductor.

A containment space is formed as a sealed space inside an NMR measurement cell. When the NMR generated in the battery sample is to be measured while repeatedly charging and discharging the battery sample in a state in which the battery cell is contained in the containment space, two conductors must be provided across an inside and an outside of the cell. When the two conductors are integrated with the battery sample, it becomes difficult to replace only the two conductors. Even when the two conductors are provided as separate members from the battery sample, if an adhesive is to be introduced into a gap between a cell body and the two conductors in order to seal the gap, similar to the above configuration, it becomes difficult to replace the two conductors. In addition, this configuration hinders reuse of the cell body. In tests and measurements of a battery sample, contamination and corrosion tend to easily occur in the conductors. In order to address degradation of the conductors, a configuration which allows easy replacement of the conductors while securing the sealing property of the containment space is desired.

An advantage of the present disclosure lies in providing, in an NMR measurement cell, replaceable conductors for charging and discharging while securing sealing property of the cell. Alternatively, an advantage of the present disclosure lies in provision of an NMR measurement probe in which an orientation of the NMR measurement cell can be changed.

### SUMMARY

According to one aspect of the present disclosure, there is provided an NMR measurement cell comprising a cell body having a containment space, in which a battery sample comprising a first electrode layer and a second electrode layer is contained, formed therein; a first pin that is inserted into a first pin hole formed in the cell body, and that is electrically connected to the first electrode layer, for charging and discharging of the battery sample; a second pin that is inserted into a second pin hole formed in the cell body, and that is electrically connected to the second electrode layer, for charging and discharging of the battery sample; a first elastic member that seals between the first pin hole and the first pin while allowing insertion and removal movements of the first pin; and a second elastic member that seals between the second pin hole and the second pin while allowing insertion and removal movements of the second pin.

According to another aspect of the present disclosure, there is provided an NMR measurement probe comprising the NMR measurement cell; a retainer that retains the NMR measurement cell; and an NMR measurement coil provided at a periphery of the NMR measurement cell, wherein the NMR measurement cell has a central axis, the retainer retains the NMR measurement cell in a manner to allow a rotational angle of the NMR measurement cell about the central axis to change, and the retainer has a lock mechanism which locks the rotational angle.

### BRIEF DESCRIPTION OF DRAWINGS

Embodiments of the present disclosure will be described based on the following figures, wherein:
FIG. 1 is a diagram showing an NMR measurement probe according to an embodiment of the present disclosure;
FIG. 2 is a front view showing a retainer;
FIG. 3 is a cross-sectional diagram showing the retainer;
FIG. 4 is a front view showing a measurement unit;
FIG. 5 is a perspective diagram showing a cell;
FIG. 6 is a side view showing the cell;
FIG. 7 is a cross-sectional diagram showing the cell;
FIG. 8 is a diagram showing a first subassembly and a second subassembly;
FIG. 9 is a diagram showing a battery sample, a first connection member, and a second connection member;
FIG. 10 is a diagram showing a flow of a temperature varying gas;
FIG. 11 is a flowchart showing a measurement method according to an embodiment of the present disclosure; and
FIG. 12 is a diagram showing an NMR measurement cell according to another embodiment of the present disclosure.

### DESCRIPTION OF EMBODIMENTS

Embodiments of the present disclosure will now be described with reference to the drawings.

### (1) Overview of Embodiments

An NMR measurement cell according to an embodiment of the present disclosure comprises a cell body, a first pin, a second pin, a first elastic member, and a second elastic member. The cell body has a containment space, in which a battery sample comprising a first electrode layer and a second electrode layer is contained, formed therein. The first pin is inserted into a first pin hole formed in the cell body, and is electrically connected to the first electrode layer, for charging and discharging of the battery sample. The second pin is inserted into a second pin hole formed in the cell body, and is electrically connected to the second electrode layer, for charging and discharging of the battery sample. The first elastic member seals between the first pin hole and the first pin while allowing insertion and removal movements of the first pin. The second elastic member seals between the second pin hole and the second pin while allowing insertion and removal movements of the second pin.

According to the configuration described above, because the first elastic member is provided between the first pin and the first pin hole, the first pin can be easily replaced, and the sealing property of the containment space can be secured. Similarly, because the second elastic member is provided between the second pin and the second pin hole, the second pin can be easily replaced, and the sealing property of the containment space can be secured. For example, a degraded pin is replaced with a new pin, or a pin formed from a certain material is replaced with a pin formed from a different material.

The battery sample corresponds to an electrochemical device. The battery sample normally has a plurality of layers which are laminated. The plurality of layers include a positive electrode layer and a negative electrode layer. For example, the first electrode layer is a conductive layer joined to the positive electrode layer, or is the positive electrode layer itself. The second electrode layer is a conductive layer joined to the negative electrode layer, or is the negative electrode layer itself.

In an embodiment of the present disclosure, the first pin is formed from a first material which is of a same kind as a material forming the first electrode layer. The second pin is formed from a second material which is of a same kind as a material forming the second electrode layer, and which differs from the first material. According to this configuration, corrosion due to contact between different metals (galvanic corrosion) caused under a corrosive environment can be prevented or reduced. The pin may be formed from the same material as the material of the electrode layer, or from a similar material as the material of the electrode layer. In general, when the primary component of the material of the electrode layer and the primary component of the material of the pin match each other, a relationship of the material of the same kind is satisfied. In the batteries, normally, the material forming the first electrode layer differs from the material forming the second electrode layer.

The NMR measurement cell according to an embodiment of the present disclosure comprises a pin series including a plurality of pins formed from a plurality of materials which differ from each other. The first pin and the second pin are each selected from the pin series. The pin series including a plurality of pins of various materials is prepared, and two pins to be used are selected according to the battery sample to be measured, more specifically, according to the material of the first electrode layer and the material of the second electrode layer. The plurality of pins included in the pin series have the same form. Alternatively, a plurality of pins having different forms may be prepared.

The NMR measurement cell according to an embodiment of the present disclosure comprises a first connection member and a second connection member. The first connection member is formed from a first material, and electrically connects the first pin and the first electrode layer. The second connection member is formed from a second material, and electrically connects the second pin and the second electrode layer. According to this configuration, the galvanic corrosion can be prevented or reduced, as described above.

In an embodiment of the present disclosure, the first connection member has an end which physically contacts the first electrode layer and which elastically deforms. The second connection member has an end which physically contacts the second electrode layer and which elastically deforms. According to this configuration, contact resistance between the first electrode layer and the first connection member, and contact resistance between the second electrode layer and the second connection member can be reduced. Alternatively, each end may be machined as a spring or an elastic piece. Alternatively, the connection members may be deformed, to thereby adjust the positions of respective ends.

In an embodiment of the present disclosure, the first elastic member is a plurality of elastic rings arranged along an axial direction of the first pin. The second elastic member is a plurality of elastic rings arranged along an axial direction of the second pin. According to this configuration, the gap between the first pin hole and the first pin can be reliably sealed, and the gap between the second pin hole and the second pin can be reliably sealed. When gas is generated in the battery sample due to charging and discharging of the battery sample, the gas does not inadvertently flow to the outside. Each elastic ring is formed from an elastic member.

In an embodiment of the present disclosure, the cell body is formed from a first portion and a second portion. The containment space is formed in a coupled state of the first portion and the second portion. The first pin hole is formed in the first portion, and the second pin hole is formed in the second portion. According to this configuration, complication of the structure of either one of the first potion and the second portion can be avoided. As a result, thicknesses of the first portion and the second portion can be reduced.

In an embodiment of the present disclosure, a direction of the first pin hole and a direction of the second pin hole are opposite from each other. According to this configuration, a position at which a first signal line is connected to the first pin and a position at which a second signal line is connected to the second pin can be set distanced from each other, and workability can thus be improved. In addition, the possibility of inadvertent short-circuiting between the signal lines can be reduced.

In an embodiment of the present disclosure, at least one of the first portion and the second portion has a passage in communication with the containment space. Gas generated in the battery sample is evacuated through the passage. Alternatively, a gas chromatograph may be connected to the passage via a tube. Further alternatively, a mass spectrometer may be connected to the gas chromatograph.

In an embodiment of the present disclosure, the cell body has an x direction which is a width direction, a y direction which is a central axis direction, and a z direction which is a thickness direction. The cell body has a first end, an intermediate portion, and a second end, which are arranged along the y direction. In the z direction, a thickness of the intermediate portion is smaller than a thickness of the first end and a thickness of the second end. According to this configuration, when the temperature of the battery sample is varied through ejection of a temperature varying gas to the cell, superior thermal conduction to the battery sample can be realized. Alternatively, the temperature of the battery sample may be varied through other methods.

In an embodiment of the present disclosure, the containment space comprises a first inner surface and a second inner surface which extend in the x direction and the y direction, and which intersect the z direction. The intermediate portion has a first exposed surface which extends along the first inner surface, and a second exposed surface which extends along the second inner surface. The first exposed surface is a first outer surface, and the second exposed surface is a second outer surface. For example, the first inner surface and the first exposed surface are parallel to each other, and the second inner surface and the second exposed surface are parallel to each other. The temperature varying gas contacts the first exposed surface and the second exposed surface.

An NMR measurement probe according to an embodiment of the present disclosure comprises the NMR measurement cell described above, a retainer, and an NMR measurement coil. The retainer retains the NMR measurement cell. The NMR measurement coil is provided at a periphery of the NMR measurement cell. The NMR measurement cell has a central axis. The retainer retains the NMR measurement cell in a manner to allow a rotational angle of the NMR measurement cell about the central axis to change. The retainer has a lock mechanism which locks the rotational angle.

According to this configuration, an orientation of the battery sample can be changed with respect to a static magnetic field. For example, the rotational angle of the battery sample is changed according to a crystal orientation of a particular substance in the battery sample. Alternatively, the rotational angle of the battery sample is changed in order to examine the crystal orientation. The rotational angle of the battery sample is changed stepwise or continuously. Alternatively, two rotational axes which are orthogonal to each other may be provided.

In an embodiment of the present disclosure, the lock mechanism includes a plurality of grooves formed on one of the cell body and the retainer, and a lock pin provided on the other of the cell body and the retainer, and which is inserted into a particular groove selected from among the plurality of grooves. According to this configuration, the rotational angle can be easily locked. The mechanism for changing and locking the rotational angle of the battery sample can also be called a goniometer mechanism.

### (2) Details of Embodiments

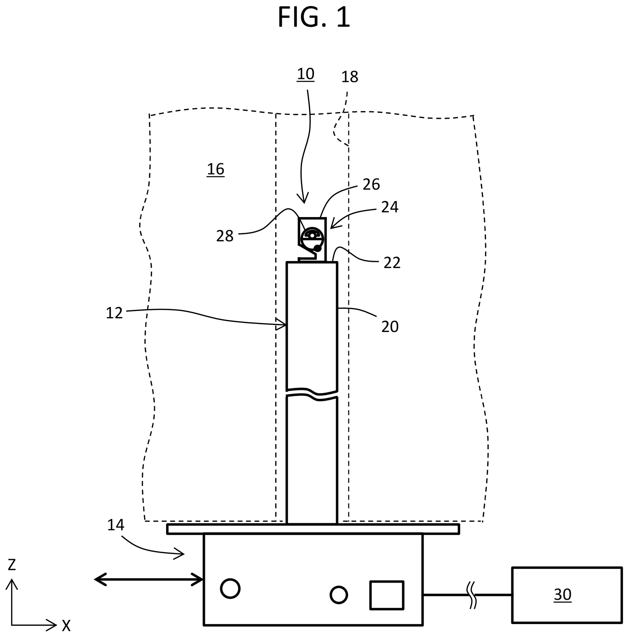

FIG. 1 shows an NMR measurement system for measuring a battery sample during charging and discharging of the battery sample. The NMR measurement system comprises an NMR measurement probe 10 (hereinafter simply referred to as a "probe") according to an embodiment of the present disclosure. The battery sample is, for example, a portion of a lithium ion battery or a solid-state battery.

The NMR measurement system further comprises a spectrometer (not shown), a static magnetic field generation apparatus 16, a charge and discharge apparatus 30, a gas analysis apparatus (not shown), and the like. The spectrometer has a transmitter, a receiver, a spectrum generator, and the like. The static magnetic field generation apparatus 16 is formed from a superconductive magnet. The charge and discharge apparatus 30 is used for charring and discharging the battery sample. In the embodiment of the present disclosure, while the battery sample is repeatedly charged and discharged, the NMR generated in the battery sample is measured.

The gas analysis apparatus is formed from, for example, a gas chromatograph, or is formed from a gas chromatograph and a mass spectrometer provided downstream thereof. The gas analysis apparatus analyzes gas generated in the battery sample during charging and discharging of the battery sample. A supply facility for temperature varying gas is provided as necessary, in order to set the temperature of the battery sample to a desired temperature.

In FIG. 1, an X direction is a first horizontal direction, and a Z direction is a vertical direction. In FIG. 1, a Y direction, which is a second horizontal direction, is not shown. The Z direction is a direction of a static magnetic field. The X direction, the Y direction, and the Z direction are in an orthogonal relationship with each other.

The probe 10 is formed from an insertion portion 12 and a base 14. The insertion portion 12 is inserted into a bore 18 of the static magnetic field generation apparatus 16. The base 14 is disposed at an outer side of the static magnetic field generation apparatus 16. The base 14 and the spectrometer are connected to each other via a cable. In addition, the base 14 and the charge and discharge apparatus 30 are connected to each other via a cable. The insertion portion 12 has a circular column portion 20 and a measurement unit 24. The circular column portion 20 has an upper surface 22 which functions as a pedestal, and the measurement unit 24 is fixed with respect to the upper surface 22.

The measurement unit 24 has a retainer 26 and an NMR measurement cell 28 (hereinafter simply referred to as a "cell"). The cell 28 is a container which contains the battery sample. The cell 28 has a central axis. The central axis is parallel to the Y direction in FIG 1.

The retainer 26 retains the cell 28 in a rotatable manner about the central axis thereof. The retainer 26 has a lock mechanism which locks a rotational angle of the cell 28, as will be described later. The cell 28 is disposed in such a manner that the central axis of the cell 28 coincides with a central axis of a coil to be described later.

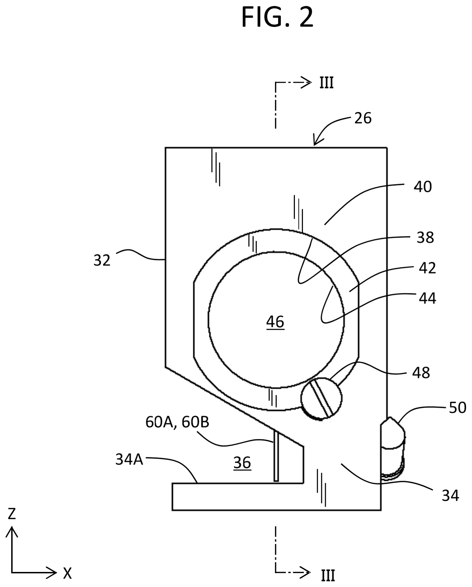

FIG. 2 shows the retainer 26. The retainer 26 has a retainer body 32 and a leg portion 34. The leg portion 34 supports the retainer body 32. A base 34A of the leg portion 34 is fixed with respect to the circular column portion described above. A wedge shape gap is present between the base 34A and the retainer body 32. An NMR measurement coil is incorporated in the retainer 26. In FIG. 2, a pair of leg portions 60A and 60B of the coil are shown. Electric components such as a capacitor may be disposed in the above-described gap of the wedge shape. Alternatively, a terminal stage to which a first signal line and a second signal line are connected may be provided with respect to the base 34A.

The retainer 26 has a cylindrical measurement space 46 which extends in the Y direction. The cell (not shown) is disposed in the measurement space 46. The retainer body 32 has an opening edge 40 surrounding an opening 38. As will be described later, with the opening edge 40, a large-diameter portion at a first end of the cell body is retained. The opening 38 has a circular shape when viewed from the Y direction. Because an end in the Y direction of the retainer body 32 has a rounded shape when viewed from the Z direction, in FIG. 2, the opening 38 is expressed as a loop including two straight lines. Reference numeral 42 indicates an opening edge which is present at a deeper side relative to the opening edge 40. The opening edge 42 surrounds an opening 44. With the opening edge 42, a small-diameter portion at the first end of the cell body is retained.

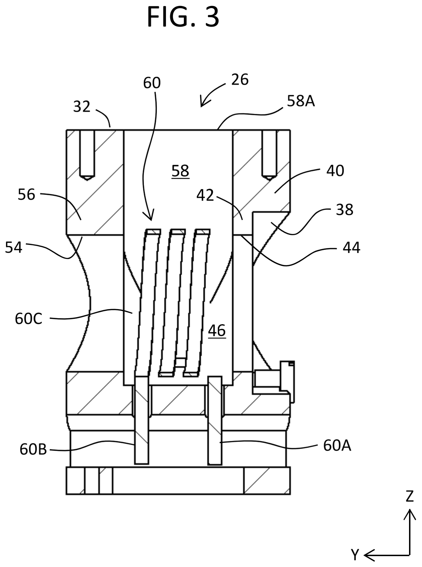

A lock pin 48 is a member for fixing the rotational angle of the cell. An axial direction of the lock pin is parallel to the Y direction. Reference numeral 50 indicates a connector portion for introducing the temperature varying gas. FIG. 3 shows a cross section along a III-III line shown in FIG. 2. The retainer 26 is formed from a nonmagnetic material, and is more specifically formed from PolyEtherEtherKetone (PEEK). Alternatively, the retainer 26 may be formed from materials such as ceramic, glass, or the like.

In FIG. 3, the coil 60 is incorporated in the retainer 26. The coil 60 has a coil body 60C surrounding the measurement space 46. The coil 60 further comprises the pair of leg portions 60A and 60B, continuous from the coil body 60C. The cell is disposed in a noncontacting manner in the coil body 60C. A central axis of the coil 60 is parallel to the Z direction, and the central axis of the coil 60 and the central axis (rotational axis) of the cell coincide each other. A gas exhaust path 58 having a well shape is formed in the retainer body 32. The gas exhaust path 58 is in communication with the measurement space 46. Reference numeral 58A indicates an outlet of the gas exhaust path 58.

The first end of the cell body is fitted to the openings 38 and 44, and is retained by the opening edges 40 and 42. More specifically, as will be described later, the first end has a large-diameter portion and a small-diameter portion. The large-diameter portion is fitted to the opening 38, and the small-diameter portion is fitted to the opening 44. A second end of the cell body is fitted to an opening 54, and is retained by an opening edge 56.

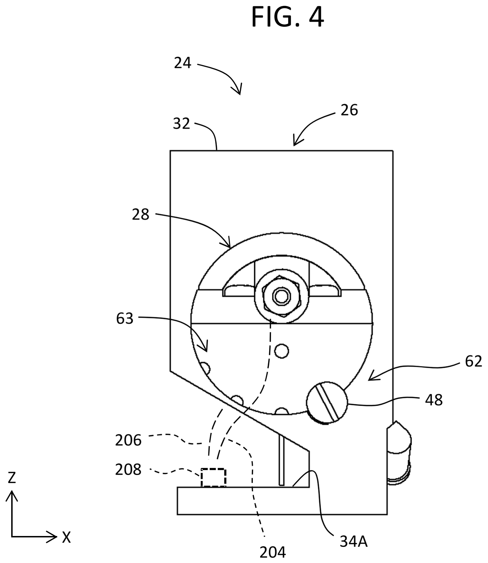

FIG. 4 shows the measurement unit 24. The cell 28 is retained by the retainer 26. In FIG. 4, the rotational angle of the cell 28 is 0 degrees. The rotational angle of the cell 28 is selected from 0 degrees, 30 degrees, 60 degrees, and 90 degrees. The cell 28 has a sequence of grooves 63 formed from four grooves corresponding to the four rotational angles.

A lock mechanism 62 is a mechanism provided across the retainer 26 and the cell 28. Alternatively, the lock mechanism 62 may be understood to be provided on the retainer 26. The lock mechanism 62 is formed from the sequence of grooves 63 and the lock pin 48. The lock pin 48 is actually a screw. Each of the grooves forming the sequence of grooves 63 has a semi-circular shape when viewed from the Y direction. One groove is formed on the retainer body. This groove also has a semi-circular shape when viewed from the Y direction. By combining two grooves, a circular hole into which the lock pin 48 is inserted is formed.

The sequence of grooves may be formed on the side of the retainer body 32, and the lock pin may be provided on the side of the cell 28. In the embodiment of the present disclosure, the rotational angle of the cell is stepwise switched, but alternatively, the rotational angle may be continuously switched. One end of a first signal line 204 is connected to a first pin provided on the cell 28. The other end of the first signal line 204 is connected to a terminal stage 208 fixed on the base 34A. One end of a second signal line 206 is connected to a second pin provided on the cell 28. The other end of the second signal line is connected to the terminal stage 208.

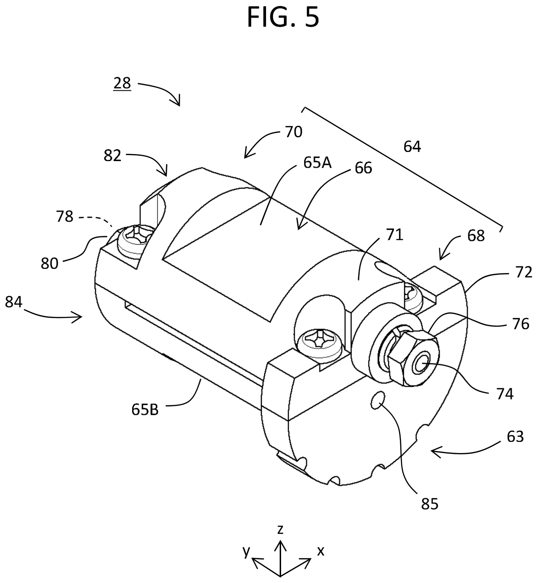

FIG. 5 shows the cell 28. A width direction is an x direction, a central axis direction is a y direction, and a thickness direction is a z direction. The x direction, the y direction, and the z direction are in the orthogonal relationship with each other.

The cell 28 comprises a cell body 64, a first pin 74, and a second pin 78. The cell body 64 has a first end 68, an intermediate portion 66, and a second end 70, which are arranged along the y direction. The first end 68 has a small-diameter portion 71 and a large-diameter portion 72. On the xz plane (when viewed from the y direction), a diameter of the large-diameter portion 72 is larger than a diameter of the small-diameter portion 71. The sequence of grooves 63 described above is formed on the large-diameter portion 72.

The second end 70 has a diameter which is equal to the diameter of the small-diameter portion 71 of the first end 68, on the xz plane. In addition, the first end 68 has an outlet 85 for exhausting the gas generated in the battery sample. The outlet 85 is connected to the gas analysis apparatus via a tube (not shown). When gas analysis is not to be performed, the outlet 85 is sealed by a sealing member.

From another point of view, the cell 28 is formed from a first subassembly (first portion) 82 and a second subassembly (second portion) 84, which are arranged in the z direction. In FIG. 5, the first subassembly 82 corresponds to an upper part and the second subassembly 84 corresponds to a lower part. Through combining of the first subassembly 82 and the second subassembly 84, a containment space is formed within the cell 28. The containment space is a sealed space, and the battery sample is disposed in the containment space.

The first subassembly 82 has the first pin 74. The second subassembly 84 has the second pin 78. A first nut 76 is attached to a base end of the first pin 74, and a second nut 80 is attached to a base end of the second pin 78. The first nut 76 and the second nut 80 are each a member for fixing a signal line. A first signal line for charging and discharging (not shown) is attached to the first pin 74 through fastening of the first nut 74, and a second signal line for charging and discharging (not shown) is attached to the second pin 78 through fastening of the second nut 80.

Notches (recesses) 65A and 65B are formed on both sides of the intermediate portion 66 in the z direction. With this configuration, in the z direction, a thickness of the intermediate portion 66 is smaller than a thickness of the first end 68 and a thickness of the second end 70.

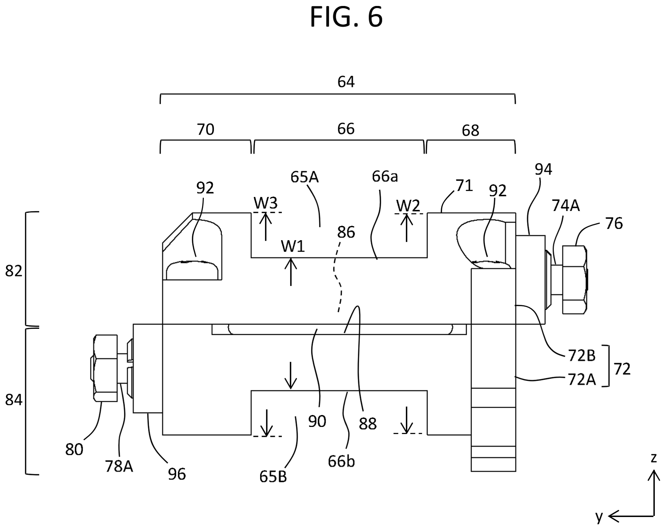

FIG. 6 shows a side surface of the cell. When the z direction is considered, the cell is generally formed from the first subassembly 82 and the second subassembly 84. When the y direction is considered, the cell body 64 is formed from the first end 68, the intermediate portion 66, and the second end 70. In the first end 68, the large-diameter portion 72 is formed from a portion 72A belonging to the second subassembly 84, and a portion 72B belonging to the first subassembly 82.

The first subassembly 82 has the first pin. The first nut 76 is attached to a base end 74A of the first pin. The first subassembly 82 has a first protrusion 94 which retains the base end 74A. The second subassembly 84 has the second pin. The second nut is attached to a base end 78A of the second pin. The second subassembly 84 has a second protrusion 96 which retains the base end 78A. The first subassembly 82 and the second subassembly 84 are fastened to each other by a plurality of screws 92.

In the z direction, a thickness W1 of the intermediate portion 66 is smaller than a thickness W2 of the first end 68 (more specifically, the small-diameter portion 71), and is smaller than a thickness W3 of the second end 70. The intermediate portion 66 has a first exposed surface 66a facing a positive side in the z direction, and a second exposed surface 66b facing a negative side in the z direction. The containment space for containing the battery sample is provided between the first exposed surface 66a and the second exposed surface 66b. By providing the first exposed surface 66a and the second exposed surface 66b close to the containment space, superior thermal conductivity can be realized.

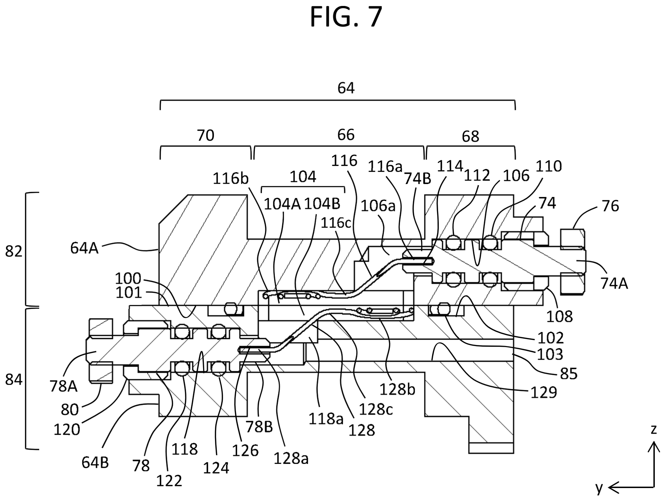

FIG. 7 shows a cross section (yz cross section) of the cell. As described above, the cell is formed from the first subassembly 82 and the second subassembly 84. The cell body 64 is formed from a first portion 64A belonging to the first subassembly 72 and a second portion 64B belonging to the second subassembly 84. The first portion 64A has a joining surface 100, and the second portion 64B has a joining surface 101. The first subassembly 82 and the second subassembly 84 are combined in such a manner that the joining surface 100 and the joining surface 101 are joined with each other.

The cell has a containment space 104 formed therein, for containing the battery sample. The containment space 104 is formed from a first portion 104A belonging to the first subassembly 82, and a second portion 104B belonging to the second subassembly 84. The second portion 64B has a groove 102 which surrounds the second portion 104B of the containment space 104. An O ring 103 which is an elastic member for sealing is disposed in the groove 102. When the first subassembly 82 and the second subassembly 84 are fastened to each other, the O ring 103 collapses, and the containment space 104 thus becomes a sealed space, that is, an airtight space.

The first portion 64A has a first pin hole 106 formed from the first end 68 to the intermediate portion 66. The first pin hole 106 is in communication with the containment space 104 via a communication passage 106a. The first pin 74 is inserted into the first pin hole 106. The first pin 74 has the base end 74A, and the first nut 76 is attached to the base end 74A. In addition, the first pin 74 has a tip end 74B. The tip end 74B has a hole 114 parallel to the y direction.

The first pin 74 has two grooves arranged in the y direction, and two O rings 110 and 112 are respectively disposed in the two grooves. Each of the two O rings 110 and 112 is formed from an elastic member, and the O rings as a whole function as a sealing member. That is, a gap between the first pin hole 106 and the first pin 74 is sealed by the two O rings 110 and 112.

The first pin 74 can be inserted and removed. A male screw formed on an outer surface of a first sleeve 108 is engaged to a female screw formed on an inner surface of the first protrusion. With this configuration, the first pin 74 is fixed with respect to the first pin hole 106. The first pin 74 can be easily removed from the first pin hole 106 by detaching the first sleeve 108.

The second portion 64B has a second pin hole 118 formed from the second end 70 to the intermediate portion 66. The second pin hole 118 is in communication with the containment space 104 via a communication passage 118a. The second pin 78 is inserted into the second pin hole 118. The second pin 78 has the base end 78A, and the second nut 80 is attached to the base end 78A. In addition, the second pin 78 has a tip end 78B.

The tip end 78B has a hole 126 parallel to the y direction.

The second pin 78 has two grooves arranged in the y direction, and two O rings 122 and 124 are respectively disposed in the two grooves. Each of the two O rings 122 and 124 is formed from an elastic member, and the O rings as a whole function as a sealing member. That is, a gap between the second pin hole 118 and the second pin 78 is sealed by the two O rings 122 and 124.

The second pin 78 can be inserted and removed. A male screw formed on an outer surface of a second sleeve 120 is engaged to a female screw formed on an inner surface of the second protrusion. With this configuration, the second pin 78 is fixed with respect to the second pin hole 118. The second pin 78 can be easily removed from the second pin hole 118 by detaching the second sleeve 120.

A first connection member 116 is provided within the containment space 104 extending from the first portion 104A to the first pin hole 106. The first connection member 116 has a first base end 116a, a first tip end 116b, and a first intermediate portion 116c. The first base end 116a is inserted into the hole 114, and is press-fitted and fixed in this state. The first tip end 116b is a portion which elastically deforms, and has a spiral coil form or a spring form. With the elastic deformation of the first tip end 116b, physical contact between the first tip end 116b and the battery sample is reinformed, and the contact resistance is consequently reduced. The first tip end 116b shown in FIG. 7 is of a flat form.

A second connection member 128 is provided within the containment space 104, extending from the second portion 104B to the second pin hole 118. The second connection member 128 has a second base end 128a, a second tip end 128b, and a second intermediate portion 128c. The second base end 128a is inserted into the hole 126, and is press-fitted and fixed in this state. The second tip end 128b is a portion which elastically deforms, and has a spiral coil form or a spring form. With the elastic deformation of the second tip end 128b, physical contact between the second tip end 128b and the battery sample is reinformed, and contact resistance is consequently reduced. The second tip end 128b shown in FIG. 7 is of a flat form.

The battery sample comprises a first electrode layer formed from a first material (first conductive material), and a second electrode layer formed from a second material (second conductive material). A material forming the first pin 74 and the first connection member 116 is of the same kind as the first material, and is in practice the same material as the first material. The first material is, for example, aluminum. By forming the plurality of members disposed in the first subassembly 82 with materials of the same kind in this manner, the galvanic corrosion under corrosive environment can be prevented or reduced. In the embodiment of the present disclosure, a material forming the first nut 76 and the first sleeve 108 is also a material of the same kind as the first material, and in practice is the same material as the first material. Alternatively, the first nut may be formed from a material different from the first material such as, for example, an insulating material such as engineering plastic. Examples of the engineering plastic include PEEK and VESPEL.

A material forming the second pin 78 and the second connection member 128 is of the same kind as the second material, and in practice is the same material as the second material. The second material is, for example, copper. By forming the plurality of members disposed in the second subassembly 84 with materials of the same kind in this manner, the galvanic corrosion under the corrosive environment can be prevented or reduced. In the embodiment of the present disclosure, a material forming the second nut 80 and the second sleeve 120 is of the same kind as the second material, and in practice is the same material as the second material. Alternatively, the second nut may be formed from a material different from the second material such as, for example, an insulating material such as engineering plastic.

The second portion 64B of the cell body 64 has a gas exhaust path (passage) 129. The gas exhaust path 129 is in communication with the containment space 104 via a space 118a. The gas exhaust path 128 has the outlet 85. The cell body 64 is formed from a nonmagnetic and insulating material, such as, for example, PEEK. Alternatively, the cell body 64 may be formed from materials such as ceramic, glass, or the like.

A configuration may be employed in which a plurality of pins having the same shape but formed from a plurality of different materials may be prepared as a series of pins (pin series), and two pins to be used are selected from among the pin series according to the material forming the first electrode layer and the material forming the second electrode layer. In this case, a connection member series, a nut series, and a sleeve series are similarly prepared.

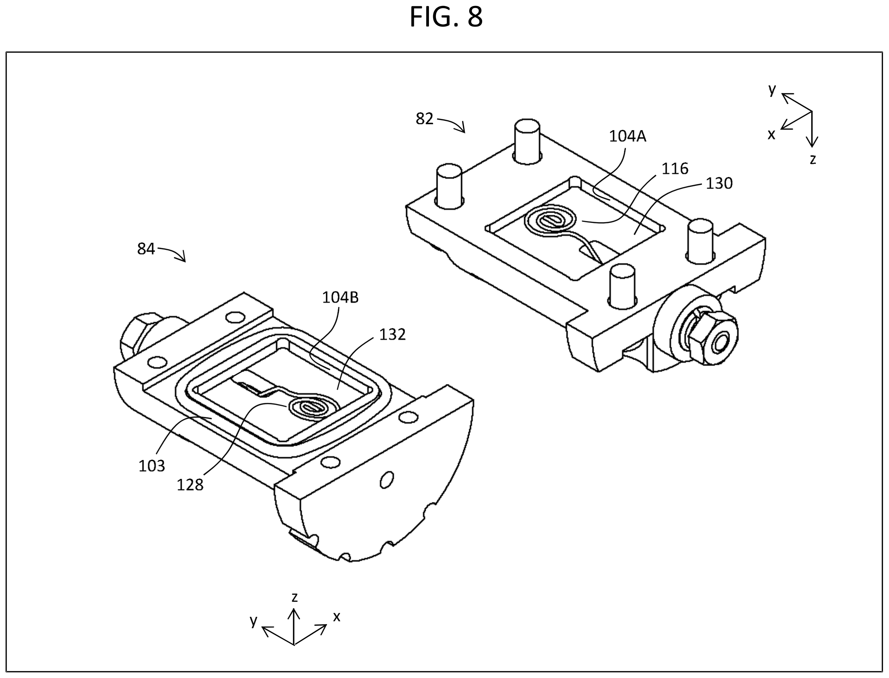

FIG. 8 shows the first subassembly 82 and the second subassembly 84. The first subassembly 82 is in an upside-down state. The first subassembly 82 has the first portion 104A serving as a recess, and the first tip end of the first connection member 116 is disposed in the first portion 104A. Reference numeral 130 indicates a ceiling surface which serves as a first inner surface.

The second subassembly 84 has the second portion 104B serving as a recess, and the second tip end of the second connection member 128 is disposed in the second portion 104B. Reference numeral 132 indicates a bottom surface which serves as a second inner surface. An annular groove is formed around the second portion 104B, and the O ring 103 is disposed in the groove.

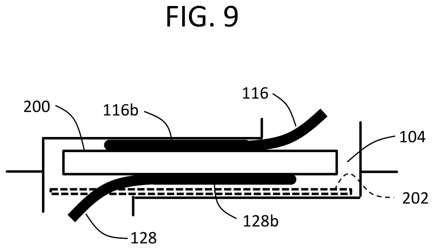

FIG. 9 shows a battery sample 200 disposed in the containment space. The battery sample 200 is a layered assembly. The battery sample 200 has, for example, a quadrangular shape or a circular shape when viewed from the z direction. The battery sample 200 has, for example, a lateral width of 7 mm to 12 mm, and a thickness of 1 mm to 3 mm.

The battery sample 200 comprises a first electrode layer and a second electrode layer. The first tip end 116b of the first connection member 116 contacts the first electrode layer, and the second tip end 128b of the second connection member 128 contacts the second electrode layer.

When the thickness of the battery sample 200 is small, a spacer 202 is disposed between the tip end 128b and the bottom surface. On the spacer 202, an opening or a notch for passing the second connection member therethrough is formed. Alternatively, a spacer may be disposed between the tip end 116b and the ceiling surface. Alternatively, a configuration may be employed in which a plurality of spacers having different thicknesses are prepared as a spacer series, and a spacer to be used is selected from among the spacer series.

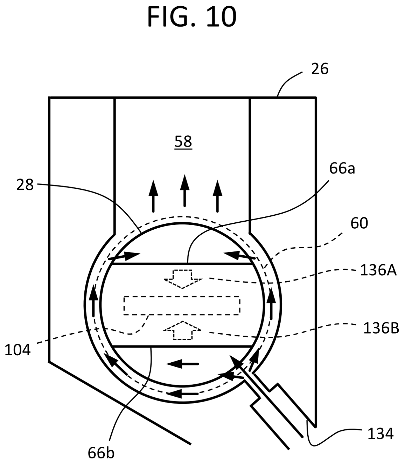

FIG. 10 shows a flow of a temperature varying gas. The cell 28 and the coil 60 are disposed in the measurement space. As the rotational angle of the cell 28, an arbitrary rotational angle is selected by a user. A gas which is sent into the retainer 26 through a gas introduction path 134 is released into the measurement space. The gas flows around the cell in such a manner as to wrap around the cell 28, and is then exhausted to the outside environment via the gas exhaust path 58. The flowing gas contacts the surface of the cell 28, in particular the gas contacts the first exposed surface 66a and the second exposed surface 66b close to the containment space. With this configuration, heat is exchanged between the cell 28 and the gas. Reference numerals 136A and 136B indicate thermal conductions within the cell 28. A temperature varying range is, for example, from -100°C to +100°C.

In the embodiment of the present disclosure, because the first exposed surface 66a and the second exposed surface 66b are set to be close to the containment space, superior thermal conduction can be realized between the battery sample and the gas, in particular the temperature of the battery sample can be quickly adjusted. Alternatively, the temperature of the battery sample may be varied through illumination of a laser light on the cell. Alternatively, a heat source may be connected to the cell via a thermal conductive member, and the temperature of the battery sample in the cell may be varied in this manner.

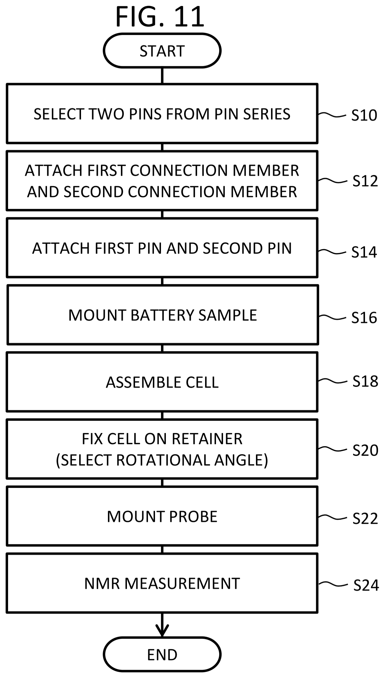

FIG. 11 shows a flowchart of a measurement method according to an embodiment of the present disclosure. At S10, a first pin and a second pin are selected from among the pin series. More specifically, a first pin formed from a material equivalent to the first material forming the first electrode layer of the battery sample is selected, and a second pin formed from a material equivalent to the second material forming the second electrode layer of the battery sample is selected. Similarly, a first connection member and a second connection member are selected from among a connection member series, a first nut and a second nut are selected from among a nut series, and a first sleeve and a second sleeve are selected from among a sleeve series.

At S12, the first base end of the first connection member is attached to the tip end of the first pin. In this process, press fitting is employed. The first connection member may be inserted into the first pin hole prior to attachment of the first connection member, or after attachment. Also at S12, the second base end of the second connection member is also attached to the tip end of the second pin. In this process, press fitting is employed. The second connection member may be inserted into the second pin hole prior to attachment of the second connection member, or after attachment.

At S14, the first pin is inserted into the first pin hole, and the first pin is attached with respect to the cell body. In this process, the first sleeve is used. The first connection member has the first tip end. For example, the first tip end is machined in a spiral coil shape. The first tip end is a portion disposed in the first portion of the containment space. Also at S14, the second pin is inserted into the second pin hole of the cell body, and the second pin is attached with respect to the cell body. In this process, the second sleeve is used. The second connection member has the second tip end. For example, the second tip end is machined in a spiral coil shape. The second tip end is a portion disposed in the second portion of the containment space. After attachment of the first pin, the first signal line is connected to the base end of the first pin. In this process, the first nut is used. After attachment of the second pin, the second signal line is connected to the base end of the second pin. In this process, the second nut is used. Alternatively, a procedure other than the procedure described above may be employed.

At S16, the battery sample is disposed in the containment space. At S18, the first portion and the second portion forming the cell are coupled, and the cell is thereby assembled. At S20, the cell is fixed with respect to the retainer. Through this process, a desired rotational angle is set.

At S22, the probe having the retainer is mounted with respect to the static magnetic field generator. At S24, NMR caused in the battery sample is measured. Then, the rotational angle of the cell is changed as required, and the NMR generated in the battery sample is again measured.

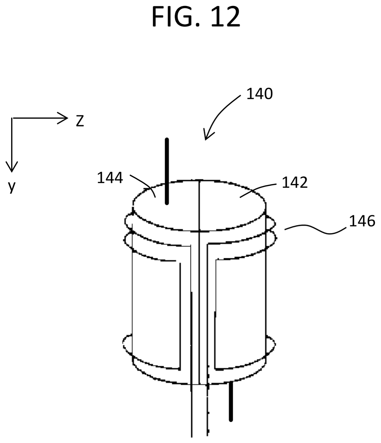

FIG. 12 shows a portion of a probe according to another embodiment of the present disclosure. A Z direction indicates a direction of a static magnetic field. A coil 146 of a saddle type is disposed in a measurement space. An internal space of the coil 146 has a circular column form. A cell 140 is disposed in the internal space. The cell 140 is formed from a first subassembly 142 and a second subassembly 144. In FIG. 12, the cell 140 is schematically shown. The cell 140 basically has a similar form and a similar structure as the cell described above with reference to FIGs. 6 to 8. However, the orientation of the cell 140 differs from the orientation of the cell shown in FIGs. 6 to 8.

With the cells of the above-described embodiments, the pin can be easily replaced while securing the sealing property of the containment space because the pins are disposed in the cell body in a manner to allow insertion and removal. For example, a degraded pin may be replaced with a new pin, or a pin formed from a certain material may be replaced with a pin formed from a different material. Replacement of the pins enables reuse of the cell body.

In the above-described embodiments, the direction of the first pin and the direction of the second pin are opposite from each other. Alternatively, the same direction may be employed for the first pin and the second pin. Setting the two directions opposite from each other results in an advantage that superior workability can be achieved. In addition, inadvertent short-circuiting can be prevented. In the above-described embodiments, the cell as a whole has a cylindrical form. Alternatively, the cell as a whole can have a flat plate or block form. In the above-described embodiments, the sample subject to measurement may be an electrochemical device other than a typical secondary battery.

## Claims

1. An NMR measurement cell (28) comprising:
a cell body (64) having a containment space (104), in which a battery sample comprising a first electrode layer and a second electrode layer is contained, formed therein;
a first pin (74) that is inserted into a first pin hole (106) formed in the cell body (64), and that is electrically connected to the first electrode layer, for charging and discharging of the battery sample;
a second pin (78) that is inserted into a second pin hole (118) formed in the cell body (64), and that is electrically connected to the second electrode layer, for charging and discharging of the battery sample;
a first elastic member (110, 112) that seals between the first pin hole (106) and the first pin (74) while allowing insertion and removal movements of the first pin (74); and
a second elastic member (122, 124) that seals between the second pin hole (118) and the second pin (78) while allowing insertion and removal movements of the second pin.

2. The NMR measurement cell (28) according to claim 1, wherein
the first pin (74) is formed from a first material which is of a same kind as a material forming the first electrode layer, and
the second pin (76) is formed from a second material which is of a same kind as a material forming the second electrode layer, and which differs from the first material.

3. The NMR measurement cell (28) according to claim 1 or 2, further comprising:
a first connection member (116) that electrically connects the first pin (74) and the first electrode layer; and
a second connection member (128) that electrically connects the second pin (76) and the second electrode layer.

4. The NMR measurement cell (28) according to claim 3, wherein
the first connection member (116) has an end (116b) which physically contacts the first electrode layer and which elastically deforms, and
the second connection member (128) has an end (128b) which physically contacts the second electrode layer and which elastically deforms.

5. The NMR measurement cell (28) according to any one of claims 1 - 4, wherein
the first elastic member is a plurality of elastic rings (110, 112) arranged along an axial direction of the first pin (74), and
the second elastic member is a plurality of elastic rings (122, 124) arranged along an axial direction of the second pin (78).

6. The NMR measurement cell (28) according to any one of claim 1 - 5, wherein the cell body (64) is formed from a first portion (82) and a second portion (84), the containment space (104) is formed in a coupled state of the first portion (82) and the second portion (84),
the first pin hole (106) is formed in the first portion (82), and
the second pin hole (118) is formed in the second portion (84).

7. The NMR measurement cell (28) according to claim 6, wherein
a direction of the first pin hole (106) and a direction of the second pin hole (118) are opposite from each other.

8. The NMR measurement cell (28) according to claim 6 or 7, wherein
at least one of the first portion (82) and the second portion (84) has a passage (129) in communication with the containment space (104), and
gas generated in the battery sample is taken out through the passage (129).

9. The NMR measurement cell (28) according to any one of claims 1 - 8, wherein
the cell body (64) has an x direction which is a width direction, a y direction which is a central axis direction, and a z direction which is a thickness direction,
the cell body (64) has a first end (68), an intermediate portion (66), and a second end (70), which are arranged along the y direction, and
in the z direction, a thickness of the intermediate portion (66) is smaller than a thickness of the first end (68) and a thickness of the second end (70).

10. The NMR measurement cell (28) according to claim 9, wherein
the containment space (104) has a first inner surface (130) and a second inner surface (132) which extend in the x direction and the y direction, and which intersect the z direction, and
the intermediate portion (66) has a first exposed surface (66a) which extends along the first inner surface (130), and a second exposed surface (66b) which extends along the second inner surface (132).

11. An NMR measurement probe (10) comprising:
the NMR measurement cell (28) according to claim 1;
a retainer (26) that retains the NMR measurement cell (28); and
an NMR measurement coil (60) provided at a periphery of the NMR measurement cell (28), wherein
the NMR measurement cell (28) has a central axis,
the retainer (26) retains the NMR measurement cell (28) in a manner to allow a rotational angle of the NMR measurement cell (28) about the central axis to change, and
the retainer (26) has a lock mechanism (62) which locks the rotational angle.

12. The NMR measurement probe (10) according to claim 11, wherein
the lock mechanism (62) includes:
a plurality of grooves (63) formed on one of the cell body (64) and the retainer (26);
and
a lock pin (48) provided on the other of the cell body (64) and the retainer (26), and which is inserted into a particular groove selected from among the plurality of grooves.
